# EUROPÄISCHE PATENTANMELDUNG

(11) **EP 0 706 205 A2**
(43) Veröffentlichungstag der Anmeldung: **10.04.1996**
(21) Anmeldenummer: 95114656.2
(22) Anmeldetag: 18.09.1995
(51) Int. Cl.: H01L 21/285

(54) **Verfahren zur planarisierenden Sputterabscheidung einer aluminiumhaltigen Schicht bei der Herstellung integrierter Schaltungen**

(30) Priorität: 19.09.1994 DE 4433326
(71) Anmelder: SIEMENS AKTIENGESELLSCHAFT, D-80333 München (DE)
(72) Erfinder: Joswig, Hellmut, Dr., Dipl.-Phys., D-81547 München (DE); Helneder, Johann, D-85652 Landsham (DE)

(57) **Zusammenfassung**

Die Sputterabscheidung wird während der Aufheizphase des Substrats, bei der die Substrattemperatur von der Raumtemperatur bis zur Verfließtemperatur erhöht wird, durchgeführt. Dadurch lassen sich die sonst auftretenden Schichtdefekte vermeiden.

## Beschreibung

Die Erfindung betrifft ein Verfahren zur planarisierenden Sputterabscheidung einer aluminiumhaltigen Schicht bei der Herstellung integrierter Schaltungen unter Einsatz einer für das Verfließen der Schicht ausreichend hohen Substrattemperatur.

Zur Metallisierung von integrierten Schaltkreisen wird in der Mikroelektronik üblicherweise eine Sputterabscheidung dünner Schichten von Aluminium oder Aluminiumlegierungen verwendet. Mit zunehmender Strukturfeinheit stößt diese Methode dort an Grenzen, wo Kontakte der Metallisierungen untereinander oder zum Siliziumsubstrat geführt werden und durch Sputtern beschichtet werden müssen. Die Aspektverhältnisse (Tiefe/Weite) dieser Kontakt- oder Vialöcher steigen mit zunehmender Strukturfeinheit immer weiter an. Als Folge von Abschattungseffekten bei der Sputterabscheidung werden die tiefen und kleinen Löcher nicht mehr oder nur ungenügend mit Material gefüllt. Infolgedessen kann es zu mangelhaftem elektrischen Anschluß kommen, oder bei der Strombelastung kommt es an diesen Stellen - wegen der geringen Schichtdicke - zu sehr hohen lokalen Stromdichten, was zu elektrischen Ausfällen und Zuverlässigkeitsrisiken führt.

Zu dieser Problematik sind bereits zwei Lösungsansätze bekannt:
a) Auffüllen der Kontakt- bzw. Vialöcher mit CVD-Methoden (z. B. Wolfram-CVD)
b) Planarisierung von Aluminium und Aluminiumlegierungen (Einsatz von hoher Substrattemperatur und/oder Anlegen einer Biasspannung beim Sputtern, und das Verfließen einer gesputterten Al-Schicht nach dem Sputterprozeß).

Die Methode a) verlangt zusätzliche Prozesse und zusätzliches Equipment; damit entstehen unerwünschte zusätzliche Kosten. Methode b) ist im Prinzip sehr elegant und einfach und damit auch kostensparend, es treten jedoch normalerweise folgende spezielle Probleme auf:
Zum Einen führt das Anlegen einer Biasspannung zu schlechtem Gefüge der gesputterten Schicht und damit zu niedriger Elektromigrationsbeständigkeit, es resultiert also ein Zuverlässigkeitsrisiko. Außerdem führt das Sputtern oder Verfließen bei hoher Temperatur zu verschiedenen Arten von Defekten:
- Spiking, d. h. Aufbrechen der Diffusionsbarriere zwischen Aluminium(legierung) und dem Siliziumsubstrat
- Benetzungsschwierigkeiten, d. h. die Aluminium(legierungs)schicht zieht sich bei den hohen Temperaturen aus dem Kontaktloch heraus (Verringerung der Oberflächenspannung). Um diesen Defekt zu vermeiden, müssen oft zusätzliche Bekeimungsschichten eingesetzt werden, beispielsweise kalt gesputtertes Aluminium, Ti, Ti/TiN oder Polysilizium.

Aufgabe der Erfindung ist daher die Schaffung eines hinsichtlich der Schichtqualität verbesserten Verfahrens der eingangs genannten Art.

Erfindungsgemäß wird dies dadurch erreicht, daß die Sputterabscheidung während der Aufheizphase des Substrats, bei der die Substrattemperatur von der Raumtemperatur bis zur Verfließtemperatur erhöht wird, durchgeführt wird.

Eine Weiterbildung der Erfindung, die im folgenden anhand eines Ausführungsbeispiels noch näher erläutert wird, ist in einem Unteranspruch angegeben.

Das erfindungsgemäße Verfahren ist optimiert im Hinblick auf die Vermeidung der oben angegebenen Defekte. Für den hier entwickelten Prozeß ist apparativ eine Heizmöglichkeit des Substrats nötig, mit der die Substrattemperatur während der Sputterabscheidung kontrolliert werden kann. Bei dem erfindungsgemäßen Prozeß wird während der Aufheizphase die Sputterabscheidung durchgeführt; man beginnt die Abscheidung bei Raumtemperatur oder bei der am Substrat vorliegenden Temperatur und endet bei einer Temperatur, die hoch genug ist, um den Verfließeffekt des Aluminium bzw. der Aluminiumlegierung zu bewirken. Es wird also während einer Temperturrampe gesputtert. Heizrate und Sputterrate müssen so aufeinander abstimmbar sein, daß die Al-Sollschichtdicke während der Temperaturrampphase abgeschieden werden kann. Durch dieses Verfahren werden die oben angegebenen Defekte (Spiking, Dewetting) vermieden:
Erstens ist die gesamte Temperaturbelastung bei dieser Abscheidung kleiner als bei einem Prozeß, bei dem erst vorgeheizt und dann heiß gesputtert wird; durch die geringe Temperaturbelastung wird Spiking verhindert. Zweitens wird am Beginn des Sputtervorgangs bei Raumtemperatur abgeschieden, d. h. bei relativ geringer Oberflächenbeweglichkeit des Al. Dadurch wird eine stabile Bekeimung und Benetzung der Kontakt/Via-Loch-Oberfläche erreicht und der Dewetting-Effekt verhindert.

Beim Test wurde ein Si-Wafer (6-Zoll) mit Oxidbeschichtung verwendet, in der Kontaktlöcher bis auf das Substrat vorhanden waren. Es ist auch keine spezielle Bekeimungsschicht nötig, die Sputterabscheidung kann direkt auf der Oxidoberfläche erfolgen. Es wird auch keine spezielle Reinigung der Wafer vor der planarisierenden Al-Abscheidung (z. B. Sputterätzen, HF-Dampf-Reinigung o.ä.) durchgeführt. Die Durchführung erfolgte auf einer Sputteranlage CLC9000 der Fa. Balzers mit
Substratheizung durch Rückseitengas (Argon), 50 sccm Fluß und mit
- Sputterkathode mit Magnetron, Target scheibenförmig.

Als typische Prozeßparameter seien genannt:

| | |
|---|---|
| Sputterleistung: | 2-10 kW |
| Sputterdruck: | 0,5-5·10⁻³ mbar |
| Temperatur bei Beginn des Sputtervorgangs: | Raumtemperatur |
| Wafertemperatur am Ende des Sputtervorgangs: | 400-550 C |
| Typische Prozeßzeit: | 40-200 sec |

## Patentansprüche

1. Verfahren zur planarisierenden Sputterabscheidung einer aluminiumhaltigen Schicht bei der Herstellung integrierter Schaltungen unter Einsatz einer für das Verfließen der Schicht ausreichend hohen Substrattemperatur,
**dadurch gekennzeichnet**,
daß die Sputterabscheidung während der Aufheizphase des Substrats, bei der die Substrattemperatur von der Raumtemperatur bis zur Verfließtemperatur erhöht wird, durchgeführt wird.

2. Verfahren nach Anspruch 1,
**dadurch gekennzeichnet,**
daß die Aufheizrate des Substrats und die Sputterrate derart aufeinander abgestimmt werden, daß die Sollschichtdicke während der Aufheizphase erreicht wird.
